# EUROPEAN PATENT SPECIFICATION

(11) **EP 1 160 352 B1**
(45) Date of publication and mention of the grant of the patent: **22.04.2009**
(21) Application number: 00111617.7
(22) Date of filing: 31.05.2000
(51) Int. Cl.: C23C 16/04, F01D 5/00, C25D 7/04

(54) **Method of adjusting the size of cooling holes of a gas turbine component**
Verfahren zum Einstellen der Grösse von Kühllöchern eines Bauteils einer Gasturbine
Méthode d'ajustement de la taille des trous de refroidissement d'un composant d'une turbine à gaz

(43) Date of publication of application: 05.12.2001
(73) Proprietor: Alstom Technology Ltd, 5400 Baden (CH)
(72) Inventor: Oehl Markus, Dr., 79761 Waldshut-Tiengen (DE); Fernihough, John, Dr., 5408 Ennetbaden (CH)

(56) References cited:
- US-A- 3 528 861
- US-A- 5 368 888
- US-A- 5 451 142
- US-A- 5 800 695
- US-A- 5 941 686
- US-A- 6 042 879

## Description

### FIELD OF INVENTION

The invention relates to a method of adjusting sizes of cooling holes of a gas turbine component .

### STATE OF THE ART

Components such as gas turbine blades, vanes and other cooled parts often contain cavities that distribute cooling air to a plurality of holes in the wall of the part that lead to the outer surface. Most turbine components are coated for protection from oxidation and/or corrosion with, for example, a MCrAIY coating (base coat) and some are also coated with a thermal barrier coating (TBC) for thermal insulation.

Cooling holes are sometimes manufactured larger than the intended size limit. This could possible happen with a new component during the production of the holes. The problem is that enlarged cooling holes lead to an increased flow of cooling air and an altered film cooling air distribution and with that a changed cooling efficiency of the components at different locations. Thus, it can affect as well the overall efficiency in an unintended and negative manner using an excessive amount of cooling air. It can also lead to an increased degradation of the base component at locations where there is a reduced cooling effect. Thus, it is the aim to provide an easy method to restore the size of the cooling holes in new components to the originally intended limits and avoid a high rate of scrapping during production of the new parts, particularly during production start-up when errors occur often.

Furthermore, the same problem occurs with components in which the size of cooling holes has been changed during service. This can happen due to oxidation, spallation and degradation of the base material exposed on the cooling hole surfaces. Again, it is the aim to find a method to repair these components rather than to use new parts by restoring the size of the cooling holes to a certain limit. For this case there are several methods known in the state of the art for repair the protective coating itself, trying to avoid the coating of the cooling holes. This is disclosed e.g. in US 4,743,462 or in US 5,800,695. But up to now there are no methods known for adjusting the size of cooling holes to bring them back to a given tolerance.

US 5,941,686 discloses a method wherein the size of a cooling passage is controlled by application of a coating.

### SUMMARY OF THE INVENTION

It is in thus an object of the invention to overcome the aforementioned disadvantages of the prior art. This is achieved in applying the method as described in claim 1. Advantageous embodiments and applications of the invention are disclosed in the further claims.

In the present invention a method according to claim 1 is found **characterised in that** the component is shielded on least at the inside with a coating of wax or plastic or other easily removable and non conducting material; the component is subjected to a coating process, such as galvanic coating or a vapour phase coating process, in which a metallic coating is applied to the inside of the cooling holes to a thickness that restores the cooling holes to intended design manufacturing tolerances, after which the shielding material is removed. A heat treatment may be applied to the component to ensure the quality of the bonding of the new applied metallic coating to the component.

With the method according to the present invention it is with advantage possible to use of a shielding directs the coating specifically to the cooling holes, provides a method of adjusting the thickness of said holes.

Where the component has two protective coatings, a metallic and a ceramic at the outside, the component is shielded during the method according to the invention with the shielding material only at the inside. On the other hand, where the component has only one protective coating, which is no ceramic coating, the component is shielded with the shielding material at both the inside and the outside.

In an example the metallic coating could have a following composition (wt-%): 25% Cr, 5.5% Al, 2.7% Si, 1.0% Ta, 0.45 - 0.8% Y, max. 0.03% C, balance Ni and unavoidable impurities. Also possible is a metallic coating such as Pt or Ni-based and containing at least one of the following components Cr, Al, Y. When the metallic coating is Pt, the Pt is applied by means of a galvanic process, and this could be followed by an aluminising process using pack aluminising, above-the-pack aluminising or any other means for depositing on top of the already deposited Pt. In another possible embodiment the metallic coating is applied by means of a high temperature chemical vapour deposition or any other gas phases means, and the portions of the component not desired to be coated are protected with a high temperature resistant masking material.

In an preferred embodiment the base component could have one of the following compositions:
A. max. 400 ppm C, 65ppm B, (wt.-%) 0.2 % Hf, 6.4% Cr, 9.6% Co, 0.6% Mo, 6.4% W, 6.5% Ta, 2.9% Re, 5.6% Al, 1.0% Ti,
B. 700 ppm C, 150 ppm B, (wt.-%) 1.4% Hf, 8.0% Cr, 9.0% Co, 0.5% Mo, 10.0% W, 3.2% Ta, 5.6% Al, 0.7% Ti,
C. max. 1600 ppm C, 150 ppm B, (wt.-%) 1.4% Hf, 8.4% Cr, 10.0% Co, 0.7%Mo, 10.0% W, 3.0% Ta, 5.5% Al, 1.0% Ti

### BRIEF DESCRIPTION OF THE DRAWINGS

The invention is illustrated by the accompanying drawings, in which
**Fig. 1** shows a gas turbine blade with cooling configuration,
**Fig. 2** shows a section through the turbine blade shown in figure 1 according to line II-II, comprising a cavity and a plurality cooling holes and
**Fig. 3 - 6** show the steps of the method according to the invention.

The drawings show only the parts important for the invention. Same elements will be numbered in the same ways in different drawings.

### DETAILED DESCRIPTION OF THE INVENTION

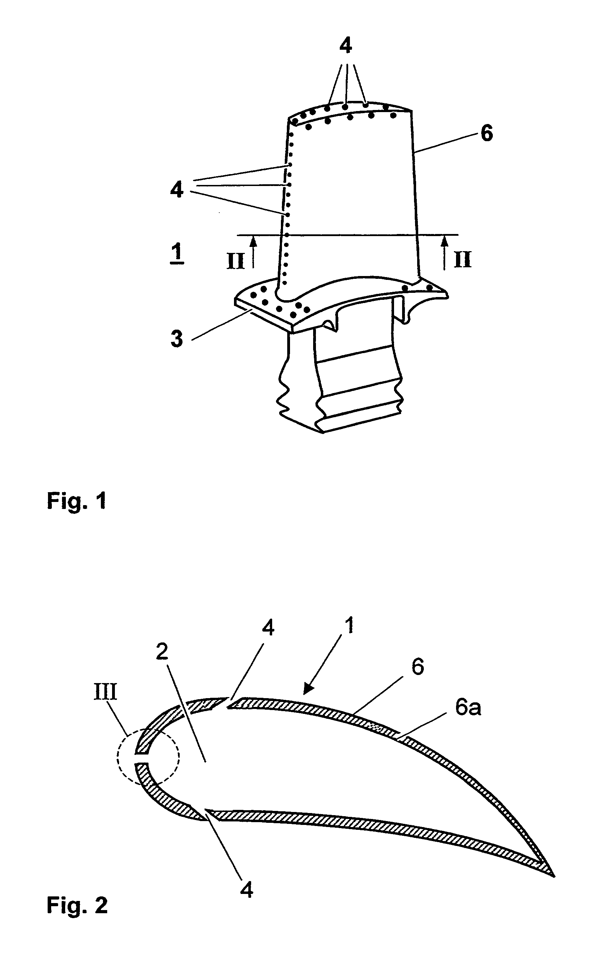

Figure 1 shows a component 1 such as blades or vanes of gas turbine engines comprising a cavity 2, not visible in figure 1, and cooling holes 4, which are on the external surface 6 of the component 1 as well as on the platform 3 of the component 1. The present invention relates to a process of adjusting the size of the cooling holes 4 to a desired tolerance by means of applying a coating within the cooling holes 4.

According to line II-II in the figure 1 figure 2 shows a section through the component 1. The component 1 comprising a cavity 2 and three cooling holes 4. The number of the cooling holes 4 is given only as an example and may vary on the purpose the component 1 is used for. The component 1 has an external surface 6 and an internal surface 6a.

It is possible to apply the process for the adjusting the size of the cooling holes 4 of a new component 1 as well as to a component 1 which has to be repaired after use. For a new component 1 the size of the cooling holes 4 might be out of a margin of tolerance which can already occur during the production of the cooling holes 4 by means of laser drilling, a spark erosion process or any similar process. In that case of an used component 1 the size of the cooling holes 4 changed by oxidation or spallation during service. Both cases lead to an undesired decreased cooling efficiency which affect on the efficiency of the whole gas turbine.

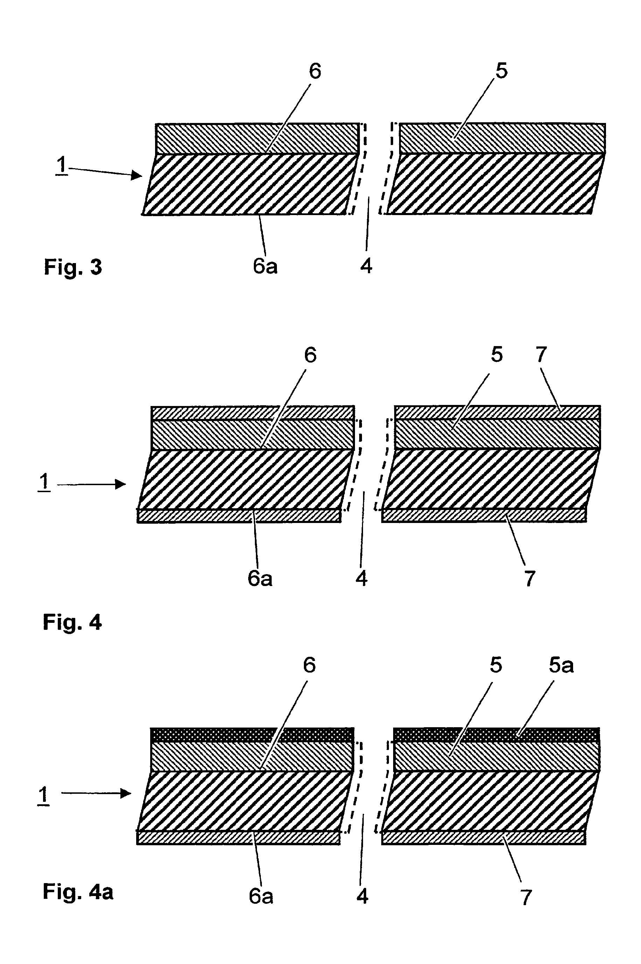

The steps of the process of the invention are given in figures 3 to 6, which show a cooling holes 4 from the component 1 in detail as given as an example in the circle III in the figure 2.

The figure 3 shows the basic component 1 at the beginning for the method according to the invention. The external surface 6 is masked with a protective coating 5 such as MCrAIY, which is prevalent in the state of the art. It is a family of high temperature coatings, wherein M is selected from one or a combination of iron, nickel and cobalt. As an example US-A-3,528,861 or US-A-4,585,418 are disclosing such kind of oxidation resistant coatings. US-A-4,152,223 as well discloses such method of coating and the coating itself. As seen from figure 3 the cooling holes 4 have greater size then desired. The margins of a tolerance within an intended limit are given by a dotted line. The aim of the method is to reach this intended limit.

Figure 4 and 4a illustrate the first steps of the method according to the present invention. The component 1 is shielded at least on side of the surface 6,6,a, which is in the figure 4,4a the inner surface 6a, with a shielding coating 7 of wax or plastic or other easily removable and non conducting material. In case, if there is a ceramic coating 5a at the outer surface this shielding coating 7 has only to be applied at the inner surface 6a, as seen in figure 4a. In contrary, figure 4 shows that both surfaces 6,6a are shielded due to a lack of this ceramic coating 5a. In general, there might be no shielding necessary at all e.g. when there is a ceramic coating at the outside and a vapour phase aluminising is used for the new coating. Before that step, in case that the diameter of the cooling holes 4 has changed due to spallation or oxidation during service of the component 1, there might be a step of cleaning the inside of the cooling holes 4 from remaining oxidised material by any suitable process such as acid cleaning, grit blasting, Fluor Ion Cleaning.

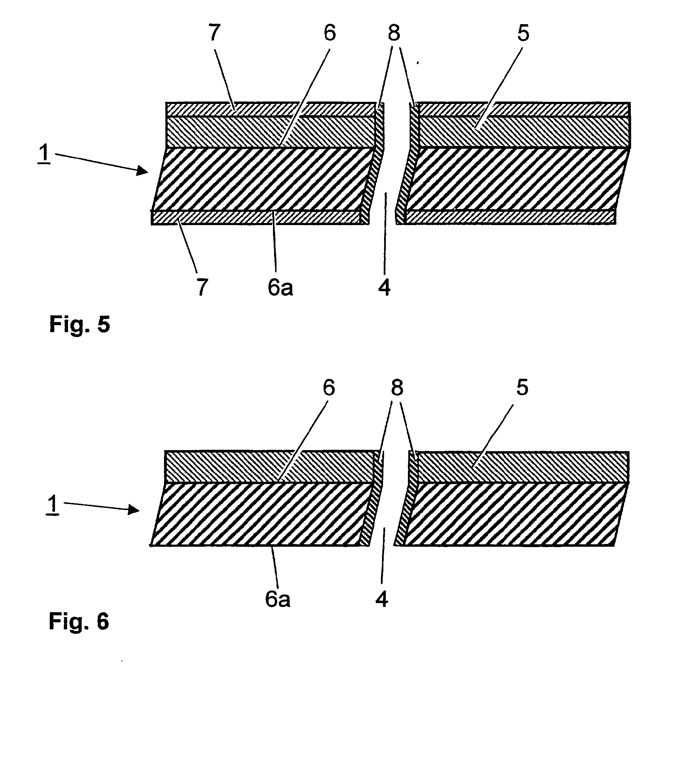

After that and as seen in figure 5, the component 1 is subjected to a coating process, such as galvanic coating or a vapour phase coating process, in which a metallic coating 8 is applied to the inside of the cooling holes 4 to a thickness that brings back the cooling holes 4 to within manufacturing tolerances. There are different possible materials which could be used for the metallic coating 8.

The metallic coating 8 could have the following composition (wt-%): 25% Cr, 5.5% Al, 2.7% Si, 1.0% Ta, 0.45 - 0.8% Y, max. 0.03% C, balance Ni and unavoidable impurities. The metallic coating 8 could be as well be Pt or Ni-based and containing at least one of the following components Cr, Al, Y. When the metallic coating 8 is Pt, the Pt may be applied by means of a galvanic process, and this is followed by an aluminising process using pack aluminising, above-the-pack aluminising or any other means for depositing on top of the already deposited Pt. The method of aluminising is described in e.g. Metals Handbook, Desk Edition (2. Edition 1998), p.1166-1170, issued by the American Society of Metals (ASM). Possible ways of deposition is known in the state of the art as chemical or physical vapour deposition (CVD, PVD). Furthermore, the metallic coating 8 could be applied by means of a high temperature chemical vapour deposition or other gas phases means, and the portions of the component not desired to coated are protected with a high temperature resistant masking material 7. This could be e.g. a paste comprising mainly metal oxides.

At the last step of the invention the shielding material 7 is removed and the dimensions of the cooling holes 4 are within desired tolerances again. This could be done e.g. by a suitable heat treatment, which melts out the wax or plastic. This is seen from figure 6. In addition a heat treatment is applied to the component 1 to ensure the quality of the bonding of the new applied metallic coating 8.

The base component 1 could have one of the following compositions:
A. max. 400 ppm C, 65ppm B, (wt-%) 0.2 % Hf, 6.4% Cr, 9.6% Co, 0.6% Mo, 6.4% W, 6.5% Ta, 2.9% Re, 5.6% Al, 1.0% Ti, balance Ni and unavoidable impurities.
B. 700 ppm C, 150 ppm B, (wt-%) 1.4% Hf, 8.0% Cr, 9.0% Co, 0.5% Mo, 10.0% W, 3.2% Ta, 5.6% Al, 0.7% Ti, balance Ni and unavoidable impurities or
C. max. 1600 ppm C, 150 ppm B, (wt-%) 1.4% Hf, 8.4% Cr, 10.0% Co, 0.7%Mo, 10.0% W, 3.0% Ta, 5.5% Al, 1.0% Ti balance Ni and unavoidable impurities.

The invention is not limited to the embodiment according to the given description but has to be seen in the scope of the enclosed claims to any component with cooling holes therein which is used in an high temperature environment such as blade or vanes, or parts of a gas turbine burner.

### NUMBERING

- **1**: Turbine blade
- **2**: Cavity
- **3**: Platform
- **4**: Cooling holes
- **5**: Protective coating (metallic coating)
- **5a**: Second protective coating (ceramic coating)
- **6**: Outer surface
- **6a**: Inner surface
- **7**: Shielding coating / shield material
- **8**: Metallic coating within cooling holes 4

## Claims

1. Method of adjusting the size of cooling holes (4) of a component (1) with an outer surface (6) and an inner surface (6a) and an internal cavity (2) with a cooling configuration, used in a high temperature environment, the component (1) comprising at least one protective coating (5,5a) at the outer surface (6) and/or at the inner surface (6a), the cooling holes (4) having a greater diameter than desired, wherein
the component (1) is subjected to a coating process, such as galvanic coating or a vapour phase coating process, in which a metallic coating (8) is applied to the inside of the cooling holes (4) to a thickness that restores the cooling holes (4) to intended design manufacturing tolerances, and wherein the component (1) is shielded on at least at one side of the surface (6, 6a) with a coating (7) of wax or plastic or other easily removable and non conducting material before the coating process and the shielding material (7) is removed after finishing the coating.

2. Method of claim 1,
**characterised in that**
after the method of claim 1 a heat treatment is applied to the component (1) to ensure the quality of the bonding of the new applied metallic coating (8).

3. Method of claim 1 or 2,
**characterised in that**
the cooling holes (4) are produced with a diameter greater than desired in the first place i.e. at a new component (1) before service after coating the component with the at least one protective coating (5,5a).

4. Method of claim 1 or 2,
**characterised in that**
the cooling holes (4) with a diameter greater than desired have become larger due to oxidation and spallation during service of the component (1).

5. Method of claim 4,
**characterised in that**
before applying the process according to claim 1 the cooling holes (4) are cleaned from remaining oxidised material by any suitable process such as acid cleaning, grit blasting, Fluor Ion Cleaning.

6. Method of the claim 1,
**characterised in that**
the component (1) has two protective coatings (5,5a), a metallic and a ceramic at the outer surface (6), the component (1) is shielded with the shielding material (7) only at the inner surface (6a).

7. Method of the claim 1,
**characterised in that**
the component (1) has only one protective coating (5), which is not a ceramic coating, the component (1) is shielded with the shielding material (7) at both the inner surface (6a) and the outer surface (6).

8. Method of the claim 1,
**characterised in that**
the metallic coating (8) is applied by means of a high temperature chemical vapour deposition or other gas phases means, and the portions of the component not desired to coated are protected with a high temperature resistant masking material (7).

9. Method of one of the claims 1 - 8,
**characterised in that**
the metallic coating (8) has a following composition (wt-%): 25% Cr, 5.5% Al, 2.7% Si, 1.0% Ta, 0.45 - 0.8% Y, max. 0.03% C, balance Ni and unavoidable impurities.

10. Method of one of the claims 1 - 8,
**characterised in that**
the metallic coating (8) is Pt or Ni-based and containing at least one of the following components Cr, Al, Y.

11. Method of one of the claim 1 to 10,
**characterised in that**
the metallic coating (8) is Pt and the Pt is applied by means of a galvanic process, and this is followed by an aluminising process using pack aluminising, above-the-pack aluminising or any other means for depositing on top of the already deposited Pt.

12. Method of one of the claims 1 to 11,
**characterised in that**
the base component (1) has the following composition: max. 400 ppm C, 65ppm B, (wt-%) 0.2 % Hf, 6.4% Cr, 9.6% Co, 0.6% Mo, 6.4% W, 6.5% Ta, 2.9% Re, 5.6% Al, 1.0% Ti, balance Ni and unavoidable impurities.

13. Method of one of the claims 1 to 11,
**characterised in that**
the base component (1) has the following composition: 700 ppm C, 150 ppm B, (wt-%) 1.4% Hf, 8.0% Cr, 9.0% Co, 0.5% Mo, 10.0% W, 3.2% Ta, 5.6% Al, 0.7% Ti balance Ni and unavoidable impurities.

14. Method of one of the claims 1 to 11,
**characterised in that**
the base component (1) has the following composition: max. 1600 ppm C, 150 ppm B, (wt-%) 1.4% Hf, 8.4% Cr, 10.0% Co, 0.7%Mo, 10.0% W, 3.0% Ta, 5.5% Al, 1.0% Ti balance Ni and unavoidable impurities.

15. Method of any of the claims 1 to 14,
**characterised in that**
the component is a blade or a vane or a part of a burner chamber within a gas turbine.

## Patentansprüche

1. Verfahren zum Einstellen der Grösse von Kühlöffnungen (4) eines Bauteils (1) mit einer äusseren Oberfläche (6) und einer inneren Oberfläche (6a) und einem inneren Hohlraum (2) mit einer in einer Hochtemperaturumgebung zur Anwendung gelangenden Kühlkonfiguration, wobei das Bauteil (1) mindestens eine Schutzbeschichtung (5, 5a) an der äusseren Oberfläche (6) und/oder an der inneren Oberfläche (6a) aufweist, wobei die Kühlöffnungen (4) einen grösseren Durchmesser als das erwünschte Mass aufweisen, wobei
das Bauteil (1) einem Beschichtungsprozess, wie etwa einer galvanischen oder einer Dampfphasen-Beschichtung unterzogen wird, bei welchem Beschichtungsprozess eine metallische Beschichtung (8) auf der Innenseite der Kühlöffnungen (4) bis zu einer Dicke aufgebracht wird, welche die Kühlöffnungen (4) in die ursprünglichen Herstellungstoleranzen zurückführt, und wobei das Bauteil (1) vor dem Beschichtungsprozess auf mindestens einer Seite der Oberfläche (6, 6a) mit einer abschirmenden Beschichtung (7) aus Wachs oder Kunststoff oder einem anderen leicht entfernbaren und nicht leitenden Material versehen wird, und dass die abschirmende Beschichtung (7) nach Beendigung des Beschichtungsprozesses entfernt wird.

2. Verfahren nach Anspruch 1,
**dadurch gekennzeichnet, dass** nach dem Verfahren gemäss Anspruch 1 das Bauteil (1) einer Wärmebehandlung unterzogen wird, um die notwendige Haftungsstärke der neu aufgebrachten metallischen Beschichtung (8) sicherzustellen.

3. Verfahren nach Anspruch 1 oder 2,
**dadurch gekennzeichnet, dass**
die Kühlöffnungen (4) mit einem grösseren Durchmesser hergestellt werden, als ursprünglich erwünscht ist, hinsichtlich eines neuen Bauteil (1), vor dessen Betrieb nach dem Beschichtungsprozess mit mindestens einer Schutzbeschichtung (5, 5a).

4. Verfahren nach Anspruch 1 oder 2,
**dadurch gekennzeichnet, dass**
die Kühlöffnungen (4) mit einem grösseren Durchmesser als festgelegt hergestellt werden, zur Auffangung des vergrössernden Einflusses von Oxidation und Spallation während des Betriebs des Bauteils (1).

5. Verfahren nach Anspruch 4,
**dadurch gekennzeichnet, dass**
vor der Durchführung des Verfahrens nach Anspruch 1 die Kühlöffnungen (4) durch einen beliebigen geeigneten Prozess wie etwa Säurereinigung, Strahlen mit körnigem Strahlmittel, Fluorionenreinigung von einem verbleibenden oxidierten Material gereinigt werden.

6. Verfahren nach Anspruch 1,
**dadurch gekennzeichnet, dass**
das Bauteil (1) an der äusseren Oberfläche (6) zwei Schutzbeschichtungen (5, 5a) aufweist, wobei die eine metallischer und die andere keramischer Natur sind, und (wobei das Bauteil (1) nur an der inneren Oberfläche (6a) mit der abschirmenden Beschichtung (7) versehen wird.

7. Verfahren nach Anspruch 1,
**dadurch gekennzeichnet, dass**
das Bauteil (1) nur eine Schutzbeschichtung (5) aufweist, die keine keramische Beschichtung ist, wobei das Bauteil (1) mit dem Abschirmungsmaterial (7) sowohl an der inneren Oberfläche (6a) als auch an der äusseren Oberfläche (6) abgeschirmt wird.

8. Verfahren nach Anspruch 1,
**dadurch gekennzeichnet, dass**
die metallische Beschichtung (8) mit Hilfe einer chemischen Hochtemperaturdampfabscheidung oder einer anderen Gasphasenmitteln aufgebracht wird, und wobei die unbeschichtet bleibenden Abschnitte des Bauteils (1) mit einer hochtemperaturbeständigen abschirmenden Beschichtung (7) geschützt werden.

9. Verfahren nach einem der Ansprüche 1-8,
**dadurch gekennzeichnet, dass**
die metallische Beschichtung (8) die folgende Zusammensetzung aufweist (Gew.-%): 25% CR, 5,5% Al, 2,7% Si, 1, 0% Ta, 0,45 - 0,8% Y, max. 0,03% C, der Rest Ni und unvermeidliche Verunreinigungen.

10. Verfahren nach einem der Ansprüche 1-8,
**dadurch gekennzeichnet, dass**
die metallische Beschichtung (8) Pt- oder Nibasiert ist und mindestens eine der folgenden Komponenten Cr, Al, Y enthält.

11. Verfahren nach einem der Ansprüche 1-10,
**dadurch gekennzeichnet, dass**
die metallische Beschichtung (8) Pt ist und das Pt mit Hilfe eines galvanischen Prozesses aufgebracht wird und dies gefolgt wird von einem Alitierungsprozess unter Verwendung von Pack-Alitieren, Above-the-Pack-Alitieren oder beliebigen anderen Mitteln zum Abscheiden auf der Oberfläche des bereits abgeschiedenen Pt.

12. Verfahren nach einem der Ansprüche 1-11,
**dadurch gekennzeichnet, dass**
das Bauteil (1) die folgende Zusammensetzung aufweist:
max. 400 ppm C, 65 ppm B, (Gew.-%) 0,2% Hf, 6,4% Cr, 9,6% Co, 0,6% Mo, 6,4% W, 6,5% Ta, 2,9% Re, 5,6% Al, 1,0% Ti, Rest Ni und unvermeidbare Verunreinigungen.

13. Verfahren nach einem der Ansprüche 1-11,
**dadurch gekennzeichnet, dass**
das Bauteil (1) die folgende Zusammensetzung aufweist:
700 ppm C, 150 ppm B, (Gew.-%) 1,4% Hf, 8,0% Cr, 9,0% Co, 0,5% Mo, 10,0% W, 3,2% Ta, 5,6% Al, 0,7% Ti, Rest Ni und unvermeidbare Verunreinigungen.

14. Verfahren nach einem der Ansprüche 1-11,
**dadurch gekennzeichnet, dass**
das Bauteil (1) die folgende Zusammensetzung aufweist:
max. 1600 ppm C, 150 ppm B, (Gew.-%) 1,4% Hf, 8,4% Cr, 10,0% Co, 0,7% Mo, 10,0% W, 3,0% Ta, 5,5% Al, 1,0% Ti, Rest Ni und unvermeidbare Verunreinigungen.

15. Verfahren nach einem der Ansprüche 1-14,
**dadurch gekennzeichnet, dass**
das Bauteil (1) eine Laufschaufel oder eine Leitschaufel oder ein Teil einer Brennerkammer innerhalb einer Gasturbine ist.

## Revendications

1. Procédé d'ajustement de la taille de trous de refroidissement (4) d'un composant (1) présentant une surface extérieure (6) et une surface intérieure (6a) et une cavité interne (2) possédant une configuration de refroidissement, utilisé dans un milieu à hautes températures, le composant (1) comprenant au moins un revêtement protecteur (5, 5a) au niveau de la surface extérieure (6) et/ou de la surface intérieure (6a), les trous de refroidissement (4) présentant un diamètre supérieur au diamètre souhaité,
le composant (1) étant soumis à un processus de revêtement, tel qu'un processus de revêtement galvanique ou de revêtement en phase vapeur, par lequel un revêtement métallique (8) est appliqué sur l'intérieur des trous de refroidissement (4) pour obtenir une épaisseur qui rétablit les tolérances de fabrication nominales prévues des trous de refroidissement (4), et
le composant (1) étant couvert sur au moins un côté de la surface (6, 6a) d'un revêtement (7) de cire ou de plastique ou d'une autre matière facilement éliminable et non conductrice préalablement au processus de revêtement, et la matière du revêtement (7) étant éliminée après l'achèvement du revêtement.

2. Procédé selon la revendication 1, **caractérisé en ce que,** suite au processus de la revendication 1, le composant (1) est soumis à un traitement thermique pour assurer la qualité d'adhérence du revêtement métallique (8) nouvellement appliqué.

3. Procédé selon la revendication 1 ou 2,
**caractérisé en ce que** les trous de refroidissement (4) sont réalisés avec un diamètre supérieur au diamètre souhaité au départ, autrement dit dans un nouveau composant (1) avant de l'utiliser mais après l'avoir revêtu dudit au moins un revêtement protecteur (5, 5a).

4. Procédé selon la revendication 1 ou 2,
**caractérisé en ce que** les trous de refroidissement (4) possédant un diamètre supérieur au diamètre souhaité se sont élargis en raison de l'oxydation et de l'écaillage survenus au cours de l'utilisation du composant (1).

5. Procédé selon la revendication 4, **caractérisé en ce que,** préalablement au processus selon la revendication 1, les trous de refroidissement (4) sont nettoyés à l'aide d'un processus adéquat quelconque tel qu'un nettoyage à l'acide, un décapage au sable, un nettoyage aux ions fluorure, en vue d'éliminer la matière oxydée résiduelle.

6. Procédé selon la revendication 1, **caractérisé en ce que** le composant (1) présente deux revêtements protecteurs (5, 5a), l'un métallique l'autre céramique au niveau de la surface extérieure (6), et le composant (1) est couvert de la matière du revêtement (7) uniquement au niveau de la surface intérieure (6a).

7. Procédé selon la revendication 1, **caractérisé en ce que** le composant (1) présente un seul revêtement protecteur (5), autre qu'un revêtement céramique, et le composant (1) est couvert de la matière du revêtement (7) au niveau à la fois de la surface intérieure (6a) et de la surface extérieure (6).

8. Procédé selon la revendication 1, **caractérisé en ce que** le revêtement métallique (8) est appliqué au moyen d'un dépôt chimique en phase vapeur à hautes températures ou par d'autres moyens en phases gazeuses, et les parties du composant que l'on ne souhaite pas revêtir sont protégées par une matière de masquage (7) résistant aux hautes températures.

9. Procédé selon l'une des revendications 1 à 8, **caractérisé en ce que** le revêtement métallique (8) possède la composition suivante (% en poids) : 25% Cr, 5,5% Al, 2,7% Si, 1,0% Ta, 0,45 - 0,8% Y, maxi. 0,03% C, reste Ni et impuretés inévitables.

10. Procédé selon l'une des revendications 1 à 8, **caractérisé en ce que** le revêtement métallique (8) est à base de Pt ou de Ni et contient au moins un des composants suivants: Cr, Al, Y.

11. Procédé selon l'une des revendications 1 à 10, **caractérisé en ce que** le revêtement métallique (8) est le Pt, et le Pt est appliqué au moyen d'un processus galvanique, suivi d'un processus d'aluminisation utilisant une aluminisation en caisse, une aluminisation sur caisse ou tout autre moyen de dépôt sur le Pt déjà déposé.

12. Procédé selon l'une des revendications 1 à 11, **caractérisé en ce que** le composant (1) possède la composition suivante: maxi. 400 ppm C, 65 ppm B, (% en poids) 0,2% Hf, 6,4% Cr, 9,6% Co, 0,6% Mo, 6,4% W, 6,5% Ta, 2,9% Re, 5,6% Al, 1,0% Ti, reste Ni et impuretés inévitables.

13. Procédé selon l'une des revendications 1 à 11, **caractérisé en ce que** le composant (1) possède la composition suivante: 700 ppm C, 150 ppm B, (% en poids) 1,4% Hf, 8,0% Cr, 9,0% Co, 0,5% Mo, 10,0% W, 3,2% Ta, 5,6% Al, 0,7% Ti, reste Ni et impuretés inévitables.

14. Procédé selon l'une des revendications 1 à 11, **caractérisé en ce que** le composant (1) possède la composition suivante: maxi. 1600 ppm C, 150 ppm B, (% en poids) 1,4% Hf, 8,4% Cr, 10,0% Co, 0,7% Mo, 10,0% W, 3,0% Ta, 5,5% Al, 1,0% Ti, reste Ni et impuretés inévitables.

15. Procédé selon l'une des revendications 1 à 14, **caractérisé en ce que** le composant (1) est une aube ou une pale ou une pièce d'une chambre de combustion dans une turbine à gaz.
